# EUROPÄISCHE PATENTSCHRIFT

(11) **EP 3 508 043 B1**
(45) Veröffentlichungstag und Bekanntmachung des Hinweises auf die Patenterteilung: **09.09.2020**
(21) Anmeldenummer: 17739563.9
(22) Anmeldetag: 13.07.2017
(51) Int. Cl.: H02K 5/10, H02K 9/22, H05K 7/20, H02K 11/33

(54) **ELEKTRISCHE VORRICHTUNG MIT EINEM GEHÄUSE MIT ANDRUCKELEMENTEN**
ELECTRIC DEVICE WITH A HOUSING WITH PRESSING ELEMENTS
DISPOSITIF ÉLECTRIQUE COMPORTANT UN BOÎTIER POURVU D'ÉLÉMENTS PRESSEURS

(30) Priorität: 02.09.2016 DE 102016216672
(43) Veröffentlichungstag der Anmeldung: 10.07.2019
(73) Patentinhaber: Robert Bosch GmbH, 70442 Stuttgart (DE)
(72) Erfinder: FALKENBURGER, Andreas, 72768 Reutlingen (DE)
(86) Internationale Anmeldenummer: PCT/EP2017/067676
(87) Internationale Veröffentlichungsnummer: WO 2018/041457

(56) Entgegenhaltungen:
- DE-A1- 19 600 619
- DE-A1- 19 712 099
- DE-A1-102013 222 822

## Beschreibung

### Stand der Technik

Die Erfindung betrifft eine elektrische Vorrichtung. Die elektrische Vorrichtung weist ein Gehäuse und wenigstens eine Leiterplatte und wenigstens eine Wärmesenke auf. Das Gehäuse umschließt einen Hohlraum, wobei die Leiterplatte in dem Hohlraum aufgenommen ist. Bevorzugt ist die Leiterplatte mit der Wärmesenke wärmeleitfähig verbunden.

### Offenbarung der Erfindung

Erfindungsgemäß weist das Gehäuse einen Gehäusedeckel auf, wobei der Gehäusedeckel wenigstens ein oder mehrere - zum Beispiel zwei oder drei oder weitere - quer zu einer flachen Erstreckung des Gehäusedeckels längsaxial verschiebbar gelagertes Andruckelement, insbesondere Andruckbolzen oder Andruckstift aufweist. Das Andruckelement ist ausgebildet, in den Hohlraum eingeschoben zu werden und mindestens mittelbar oder unmittelbar gegen die Leiterplatte anzudrücken und die Leiterplatte so gegen die Wärmesenke zu pressen. Mittels des Andruckelements kann vorteilhaft eine Toleranz einer Anordnung der Leiterplatte in dem Hohlraum kompensiert werden. Verglichen mit Andruckbolzen, welche beispielsweise an den Gehäusedeckel angeformt sind, und so ein festes Längenmaß aufweisen, kann die Leiterplatte so mit einer variablen Länge des Andruckelements mittels eines Presswerkzeuges mit einer Kraft beaufschlagt werden. Beispielsweise kann so das Gehäuse zusammen mit der Leiterplatte und der Wärmesenke in ein weiteres Gehäuseteil, beispielsweise ein Gehäuse eines Elektromotors, eingepresst werden. Dadurch wird beim Aufpressen des Gehäuses auf das weitere Gehäuseteil vorteilhaft der Gehäusedeckel nicht belastet.

Die Offenlegungsschriften DE 19600619 A1, DE 197120099 A1 und DE 10201322822 A1 offenbaren beispielsweise je eine solche elektrische Vorrichtung mit einem Gehäuse, einer Leiterplatte und einer Wärmesenke.

Vorteilhaft kann das Andruckelement, beispielsweise ein Andruckbolzen oder ein Andruckstift - im Falle eines Verbleibs in der in den Hohlraum eingedrückten Verschiebeposition - ein Fixiermittel zum Halten der Leiterplatte bilden.

Bevorzugt weist der Andruckbolzen im Querschnitt eine runde, insbesondere kreisrunde oder elliptische Form auf. Dadurch kann der Andruckbolzen aufwandsgünstig zusammen mit dem Gehäusedeckel erzeugt werden und eine gute Abdichtung zu dem Gehäusedeckel erreicht werden. In einer anderen Ausführungsform weist der Andruckbolzen eine vieleckige Form im Querschnitt auf, beispielsweise eine drei-, vier-, fünf- oder sechseckige Form. Dadurch kann eine gute längsaxiale Steife des Andruckbolzens gebildet sein.

Bevorzugt weist ein Längsabschnitt des Andruckbolzens, welcher einen Teil eines aus dem Gehäusedeckel herausragenden Endabschnitts bildet, eine Signalfarbe auf. Die Signalfarbe ist beispielsweise Rot, Gelb oder Orange. Dadurch kann von außen gut von einem menschlichen Auge oder einer Erfassungsvorrichtung erfasst werden, ob der Andruckbolzen in das Gehäuse eingeschoben ist und so eine korrekte Montage des Gehäusedeckels erfolgt ist.

In einer vorteilhaften Variante ist der Andruckbolzen ausgebildet, anstelle gegen die Leiterplatte unmittelbar gegen einen Gehäuseboden des Gehäuses zu pressen. Die Leiterplatte kann beispielsweise eine Aussparung zum Durchgreifen des Andruckbolzens aufweisen. Dadurch wird beim Aufpressen des Gehäuses auf einen weiteren Gehäuseteil vorteilhaft nur der Gehäuseboden des Gehäuses belastet.

In einer bevorzugten Ausführungsform ist in dem Gehäusedeckel ein Gleitlager für den Andruckbolzen ausgebildet. Der Andruckbolzen ist in dieser Ausführungsform bevorzugt in einem Durchbruch des Gehäusedeckels hin- und herschiebbar gelagert. Der Gehäusedeckel kann so vorteilhaft gemeinsam mit dem Andruckbolzen als Andruckmittel eine gemeinsame Montageeinheit bilden.

In einer bevorzugten Ausführungsform sind der Andruckbolzen und der Gehäusedeckel jeweils aus zueinander verschiedenen Kunststoffen gebildet. Der Gehäusedeckel und der Andruckbolzen können so beispielsweise gemeinsam in einem Spritzgusswerkzeug, beispielsweise mittels IMA (IMA = In-Mould-Assembling) oder Montagespritzguss erzeugt werden. Die zueinander verschiedenen Kunststoffe sind bevorzugt ausgebildet, beim Spritzgießen voneinander getrennt zu bleiben und so miteinander nicht zu verschmelzen oder einander stoffschlüssig zu verbinden. Dadurch kann der Andruckbolzen vorteilhaft in einem Durchbruch des Gehäusedeckels hin- und herverschiebbar gelagert sein. Bevorzugt ist der Andruckbolzen aus POM (POM = Poly-Oxy-Methylen) gebildet und der Gehäusedeckel aus PBT (PBT = Poly-Butylen-Terephtalat).

In einer bevorzugten Ausführungsform weist der Andruckbolzen ein größeres Elastizitätsmodul auf als der Gehäusedeckel. Der Andruckbolzen kann so eine größere Steifigkeit aufweisen als der Gehäusedeckel. Beispielsweise ist der Andruckbolzen rohrförmig ausgebildet. Durch die Rohrform kann der Andruckbolzen vorteilhaft aufwandsgünstig bereitgestellt werden.

Bevorzugt sind der Andruckbolzen und der Gehäusedeckel jeweils durch einen Thermoplast gebildet. Beispielsweise ist der Andruckbolzen aus POM, PPS (PPS = Poly-Phenylen-Sulfid) oder PMMA (PMMA = Poly-Methyl-Meth-Acrylat) gebildet. Der Gehäusedeckel ist bevorzugt aus ABS (ABS = Acrylnitril-Butadien-Styrol), Polyamid, PBT, PEEK (PEEK = Poly-Ether-Ether-Keton) oder einem Polyalken, beispielsweise Polyethylen oder Polypropylen gebildet. Der Gehäusedeckel ist bevorzugt durch einen mittels Fasern verstärkten Kunststoff gebildet. Die Fasern sind beispielsweise Glasfasern oder Carbonfasern.

Der Andruckbolzen kann zum Verbundenwerden mit dem Gehäusedeckel beispielsweise in einen Durchbruch des Gehäusedeckels geschoben werden. Bevorzugt ist der Andruckbolzen ausgebildet, in dem Gehäusedeckel formschlüssig zu verrasten. Dazu weist der Andruckbolzen wenigstens einen Rasthaken oder Bajonetthaken auf, welcher ausgebildet ist, einen Durchbruchrand des Gehäusedeckels formschlüssig zu hintergreifen.

In einer anderen Ausführungsform ist der Andruckbolzen durch einen Duroplast und der Gehäusedeckel durch einen Thermoplast gebildet. Dazu kann beispielsweise der Gehäusedeckel in einem Montagespritzgussverfahren nach einem Erzeugen des Andruckbolzens erzeugt werden.

Bevorzugt ist eine Schmelztemperatur des Materials des Andruckbolzens kleiner als eine Schmelztemperatur des Materials des Gehäusedeckels. Vorteilhaft kann der Andruckbolzen so in einem zweiten Spritzvorgang nach dem Erzeugen des Gehäusedeckels in dem Gehäusedeckel, beispielsweise mittels IMA, erzeugt werden. Dadurch kann der Andruckbolzen beim Erzeugtwerden in dem Durchbruch des Gehäusedeckels sein Volumen verkleinern und so schwinden, so dass der Andruckbolzen in dem Gehäusedeckel entlang seiner Längsachse gleiten kann.

In einer anderen Ausführungsform weist der Gehäusedeckel eine im Bereich des Andruckbolzens ausgebildete, elastisch ausgebildete Lippe, insbesondere Federlippe oder Membran auf, welche den Andruckbolzen umgibt und mit dem Gehäusedeckel verbindet. So ist der Andruckbolzen vorteilhaft in dem Gehäusedeckel federnd axial hin- und herverschiebbar gelagert. Bevorzugt ist der Andruckbolzen mit der elastisch ausgebildeten Lippe wenigstens haftend, bevorzugt stoffschlüssig verbunden, wobei die Lippe mit dem Gehäusedeckel im Bereich des Durchbruchs, insbesondere Durchbruchrandes des Durchbruchs, stoffschlüssig und/oder formschlüssig verbunden ist. Die Lippe kann beispielsweise zur formschlüssigen Verbindung mit dem Gehäusedeckel einen Dichtungsrand aufweisen, welcher eine bevorzugt umlaufend ausgebildete Nut aufweist, welche zur Aufnahme des Durchbruchrandes des Gehäusedeckels ausgebildet ist. Vorteilhaft ist das Elastomer-Material der elastisch ausgebildeten Lippe ausgebildet, mit dem Andruckbolzen und dem Gehäusedeckel stoffschlüssig, insbesondere durch miteinander Verschmelzen oder durch Polymerbindungen, beim Spritzgießen verbunden zu werden. So kann der Gehäusedeckel gemeinsam mit der Lippe und dem Andruckbolzen in einem Mehrmaterial-Spritzgussverfahren mit zueinander verschiedenen Kunststoffen, beispielsweise einem RIM-Verfahren (RIM = Reaction-Injection-Molding), erzeugt werden. Die Lippe ist beispielsweise durch einen Silikongummi gebildet.

In einer bevorzugten Ausführungsform ist die Lippe mit dem Andruckbolzen und dem Gehäusedeckel stoffschlüssig verbunden, insbesondere verschmolzen. So kann der Gehäusedeckel vorteilhaft dicht gegen flüssige Medien, beispielsweise Wasser oder Öl, ausgebildet sein.

In einer bevorzugten Ausführungsform der Vorrichtung ist die Leiterplatte mit der Wärmesenke mittels eines Wärmeleitmittels, insbesondere eines wärmeleitfähigen Klebstoffs oder einer Wärmeleitpaste, verbunden. So kann vorteilhaft von Verlustwärme erzeugenden elektrischen Komponenten, beispielsweise eines Leistungshalbleiters, welcher mit der Leiterplatte verbunden ist, Verlustwärme von dem Leistungshalbleiter - entweder durch die Leiterplatte hindurch oder unmittelbar an das Wärmeleitmittel und weiter an die Wärmesenke abgegeben werden.

Die Erfindung betrifft auch ein Verfahren zum Andrücken einer Leiterplatte an eine Wärmesenke. Bei dem Verfahren wird die Leiterplatte in einen Hohlraum eines Gehäuses eingebracht. Bevorzugt wird die Leiterplatte mit ihrer flachen Erstreckung einer Wärmesenke gegenüberliegend angeordnet. Die Wärmesenke bildet bevorzugt wenigstens einen Teil des Gehäusebodens oder den Gehäuseboden des Gehäuses.

In einem weiteren Schritt wird das Gehäuse mit einem Gehäusedeckel verschlossen. Bevorzugt wird der Gehäusedeckel mit dem Gehäuse, insbesondere einem Gehäuserand des Gehäuses, dicht verbunden, beispielsweise verklebt oder laserverschweißt.

Bevorzugt werden wenigstens ein oder mehrere in dem Gehäusedeckel axial verschiebbar gelagerte Andruckbolzen von außen auf ein nach außen ragendes Ende des Andruckbolzens mit einer Andruckkraft beaufschlagt, und so in den Hohlraum des verschlossenen Gehäuses hineingedrückt. Der Andruckbolzen oder die Andruckbolzen können dort die Leiterplatte gegen die Wärmesenke anpressen. Mittels des vorab beschriebenen Montageverfahrens kann mittels der axial verschiebbaren Andruckbolzen ein Toleranzmaß, insbesondere ein Einbaumaß, welches einen Abstand der Leiterplatte von dem Gehäusedeckel repräsentiert, kompensiert werden. Vorteilhaft wird der Gehäusedeckel so nicht belastet und so auch nicht durchgebogen oder beschädigt.

In einer bevorzugten Ausführungsform des Verfahrens wird die Leiterplatte durch das Angedrücktwerden mittels der Andruckkraft mit der Wärmesenke wärmeleitfähig verbunden. So kann die Leiterplatte vorteilhaft aufwandsgünstig und sauber mit der Wärmesenke verbunden werden. Vorteilhaft können so nämlich beim Andrücken der Leiterplatte gegen die Wärmesenke keine Fremdkörper, beispielsweise Schmutzpartikel oder Metallabrieb oder andere Verschmutzungen, beispielsweise Medien wie Öl oder Feuchtigkeit, in das Gehäuse eindringen und dort eine elektrische Funktionsfähigkeit der Leiterplatte, insbesondere einer durch die Leiterplatte gebildeten Schaltungsanordnung, beeinträchtigen, da das Gehäuse beim Andrücken verschlossen bleibt. Das Gehäuse kann beispielsweise eine Druckkompensationsöffnung aufweisen, so dass in dem Hohlraum befindliche Luft beim Eingepresstwerden der Andruckbolzen entweichen kann.

In einer bevorzugten Ausführungsform schließt der Andruckbolzen nach dem Eingedrücktwerden in den Gehäusedeckel mit dem Gehäusedeckel bündig ab, oder ist in dem Gehäusedeckel versenkt. Vorteilhaft kann so von außen leicht erkannt werden, ob der Montageprozess vollständig und richtig durchgeführt wurde, insbesondere, ob die Leiterplatte mit der Wärmesenke wärmeleitfähig verbunden worden ist.

In einer bevorzugten Ausführungsform des Verfahrens gleitet der Andruckbolzen beim Eingedrücktwerden in den Hohlraum in einem Durchbruch des Gehäusedeckels. Der Andruckbolzen ist vorteilhaft vor einem Aufsetzen des Gehäusedeckels mit dem Gehäusedeckel verbunden und bildet so mit dem Gehäusedeckel gemeinsam eine Montageeinheit. Das Gehäuse kann so vorteilhaft aufwandsgünstig zusammengesetzt werden.

Bevorzugt wird der Gehäusedeckel gemeinsam mit dem Andruckbolzen mittels eines Spritzgussverfahrens, insbesondere Montagespritzguss, erzeugt. Der Gehäusedeckel kann so vorteilhaft aufwandsgünstig bereitgestellt werden. Weiter vorteilhaft kann so eine genaue Passung des Andruckbolzens in dem Durchbruch erzeugt werden, wobei ein Spaltmass zwischen dem Andruckbolzen und dem Gehäusedeckel beim Erzeugen des Andruckbolzens durch dessen Schwund beim Erzeugen bestimmt werden kann.

Vorteilhaft kann der Andruckbolzen nach einem Spritzen des Gehäusedeckels in einem Durchbruch des Gehäusedeckels mittels Spritzguss erzeugt werden, so dass der Andruckbolzen beim Abkühlen und/oder Verfestigen in dem Durchbruch im Längsdurchmesser auf ein vorbestimmtes Endmass schwinden, insbesondere sich verkleinern kann. Dadurch kann der Andruckbolzen in dem Durchbruch beweglich bleiben. Bevorzugt entspricht eine Werkzeugtemperatur eines den Gehäusedeckel erzeugenden Werkzeugs der Werkzeugtemperatur eines den Andruckbolzen erzeugenden Werkzeugs. Die Werkzeuge sind beispielsweise jeweils als insbesondere teilbar ausgebildete, und bevorzugt beheizbar ausgebildete Hohlform ausgebildet.

In einer anderen Ausführungsform federt der Andruckbolzen in einem Durchbruch des Gehäusedeckels beim Einpressen, wobei eine stoffschlüssige Verbindung zwischen dem Andruckbolzen und dem Gehäusedeckel beim Federn erhalten bleibt. Der Gehäusedeckel kann so vorteilhaft mediendicht ausgebildet sein.

Bevorzugt wird der Gehäusedeckel beim Verschließen des Hohlraumes mit dem Gehäuse, insbesondere einem Gehäuserand des Gehäuses, verklebt oder mittels Laserstrahlen laserverschweißt. Das Gehäuse kann so vorteilhaft mediendicht, insbesondere öl- oder wasserdicht, verschlossen werden.

In einer bevorzugten Ausführungsform wird beim Einpressen des wenigstens einen Andruckbolzens oder der Andruckbolzen, das Gehäuse zusammen mit dem Kühlkörper in einen weiteren Gehäuseteil, insbesondere einen den Gehäuseteil bildende Hülse, beispielsweise eine Motorhülse, eingepresst. Vorteilhaft kann so mittels nur eines Einpressvorgangs die Leiterplatte mit der Wärmesenke, insbesondere einem Kühlkörper, wärmeleitfähig verbunden werden und mittels desselben Einpressvorgangs das Gehäuse mit einem weiteren Gehäuseteil verbunden, insbesondere steckverbunden werden.

Die Erfindung wird nun im Folgenden anhand von Figuren und weiteren Ausführungsbeispielen erläutert. Weitere vorteilhafte Ausführungsvarianten ergeben sich aus einer Kombination der in den Figuren und in den abhängigen Ansprüchen beschriebenen Merkmalen.
Figur 1 zeigt ein Ausführungsbeispiel für eine elektrische Vorrichtung mit einem Gehäuse und einem Gehäusedeckel für das Gehäuse, wobei der Gehäusedeckel zwei verschiebbar gelagerte Andruckbolzen zum Andrücken auf eine Leiterplatte oder einen Gehäuseboden aufweist;
Figur 2 zeigt ein Ausführungsbeispiel für einen Gehäusedeckel mit längsaxial verschiebbar gelagerten Andruckbolzen in einer Schnittdarstellung;
Figur 3 zeigt eine Variante für einen Gehäusedeckel mit einem längsaxial federnd hin- und herbewegbar ausgebildeten Andruckbolzen;
Figur 4 zeigt ein Ausführungsbeispiel für einen Gehäusedeckel mit einem längsaxial in dem Gehäusedeckel verschiebbaren Andruckelement, das in dem Gehäusedeckel formschlüssig gesichert ist;
Figur 5 zeigt ein Beispiel für ein Verfahren zum Erzeugen einer elektrischen Vorrichtung, wobei bei dem Verfahren ein Gehäuse mittels verschiebbar gelagerten Andruckbolzen in ein weiteres Gehäuseteil eingepresst wird und dabei eine im Inneren des Gehäuses angeordnete Leiterplatte gegen eine Wärmesenke angepresst wird.

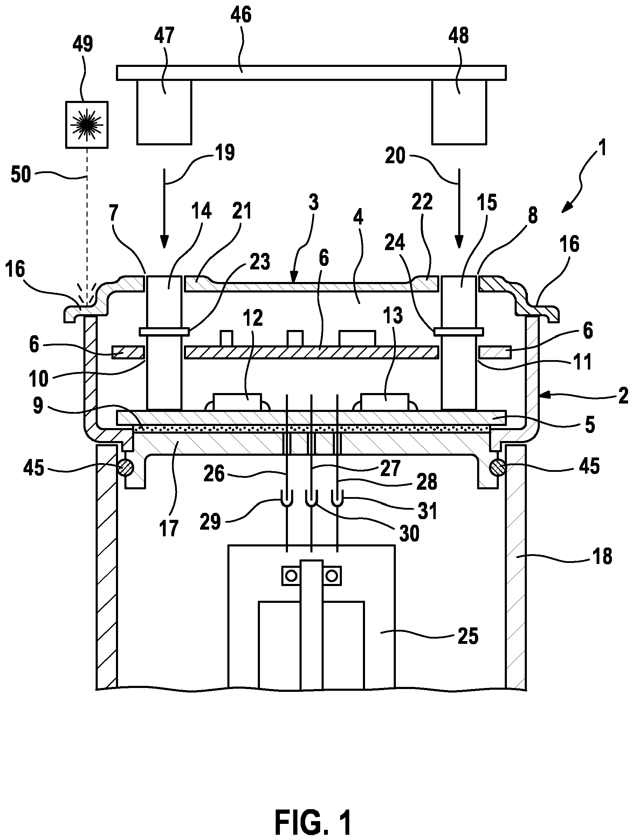

Figur 1 zeigt - schematisch - ein Ausführungsbeispiel für eine elektrische Vorrichtung 1 in einer Schnittdarstellung. Die elektrische Vorrichtung 1 bildet beispielsweise eine elektrische Maschine, insbesondere einen Elektromotor und/oder einen Generator. Die Vorrichtung 1 weist ein Gehäuse 2 auf, welches einen Gehäusedeckel 3 aufweist und gemeinsam mit dem Gehäusedeckel 3 einen Hohlraum 4 umschließt. Die Vorrichtung 1 weist auch wenigstens einen Schaltungsträger, in diesem Ausführungsbeispiel einen Schaltungsträger 5 und einen Schaltungsträger 6 auf, welche jeweils in dem Hohlraum 4 angeordnet sind.

Die Vorrichtung 1 umfasst in diesem Ausführungsbeispiel auch einen verschiebbar gelagerten Andruckbolzen 14, welcher in einem Durchbruch 7 des Gehäusedeckels 3 entlang seiner Längserstreckung verschiebbar gelagert ist. Die Vorrichtung 1 umfasst auch einen weiteren Andruckbolzen 15, welcher an dem Durchbruch 8 des Gehäusedeckels 3 entlang seiner Längserstreckung verschiebbar gelagert ist. Die Andruckbolzen 14 und 15 bilden jeweils einen Andruckbolzen zum Andrücken auf den Schaltungsträger 5.

Die Vorrichtung 1 kann zusätzlich zu den Andruckbolzen 14 und 15 noch weitere Andruckbolzen aufweisen, so dass die Vorrichtung 1 mehr als zwei Andruckbolzen, insbesondere drei, vier oder fünf Andruckbolzen aufweisen kann.

Der Schaltungsträger 6 ist in dem Hohlraum 4 zu dem Schaltungsträger 5 parallel beabstandet angeordnet, wobei der Andruckbolzen 14 durch einen Durchbruch 10 in dem Schaltungsträger 6, und der Andruckbolzen 15 durch einen Durchbruch 11 in dem Schaltungsträger 6 hindurchgeführt ist. Die Durchbrüche 10 und 11 weisen jeweils einen größeren Durchmesser auf als die durch die Durchbrüche jeweils hindurchgeführten Andruckbolzen, sodass die Andruckbolzen in den Durchbrüchen verschiebbar bewegt werden können.

Der Schaltungsträger 5 weist in diesem Ausführungsbeispiel einen Halbleiterbaustein 12 und einen Halbleiterbaustein 13 auf, welche mit dem Schaltungsträger verbunden, in diesem Ausführungsbeispiel verlötet, sind. Die Halbleiterbausteine 12 und 13 sind jeweils ausgebildet, Verlustwärme zu erzeugen, welche durch den Schaltungsträger 5 hindurch zu einer Wärmesenke 17 abgeführt werden kann, welche in diesem Ausführungsbeispiel durch einen Kühlkörper, insbesondere Aluminiumkühlkörper, gebildet ist. Die Halbleiterbausteine 12 und 13 bilden beispielsweise jeweils einen Halbleiterschalter einer Leistungsendstufe der Vorrichtung 1. Die Wärmesenke 17, welche in diesem Ausführungsbeispiel Bestandteil der Vorrichtung 1 ist, ist mittels eines Wärmeleitmittels 9, beispielsweise einer Wärmeleitpaste oder einem Wärmeleitklebstoff, mit dem Schaltungsträger 5 verbunden. Die Vorrichtung 1 umfasst auch ein Gehäuseteil 18, welches in diesem Ausführungsbeispiel durch eine insbesondere hohlzylindrisch geformte Hülse gebildet ist. In dem Gehäuseteil 18 ist in diesem Ausführungsbeispiel ein Elektromotor 25 aufgenommen. Die Wärmesenke 17 bildet in diesem Ausführungsbeispiel einen Boden des Gehäuses 2. Die Wärmesenke 17 weist in diesem Ausführungsbeispiel eine Nut für eine umlaufend ausgebildete Elastomer-Dichtung 45 auf. Das Gehäuse 2 kann so in eine Öffnung des Gehäuseteils 18 eingepresst werden, wobei wenigstens ein Teil der Wärmesenke 17 in das Gehäuseteil 18 hineinragt, und die Elastomer-Dichtung 45 die Wärmesenke 17 gegen eine Gehäusewand des Gehäuseteils 18 abdichtet.

Zum Zusammenpressen des Gehäuses 2 mit dem Gehäuseteil 18 ist eine Kraft erforderlich, welche in Form einer Kraft 19 auf dem Andruckbolzen 14 und in Form einer Kraft 20 auf dem Andruckbolzen 15 aufgebracht werden kann. Die Leiterplatte 5 wird so mit der Kraft 19 und der Kraft 20 über die Andruckbolzen 14 beziehungsweise 15 beaufschlagt, sodass das Wärmeleitmittel 9, welches zwischen der Leiterplatte 5 und der als Kühlkörper ausgebildeten Wärmesenke 17 - nach Art eines Sandwiches - eingeschlossen ist, den Schaltungsträger 5 mit der Wärmesenke 17 wärmeleitfähig verbinden kann. Nach einem Aufsetzen des Gehäuses 2 auf einen Gehäuserand des Gehäuseteils 18 kann durch Beaufschlagen der Kräfte 19 und 20 auf die Andruckbolzen 14 beziehungsweise 15 das Gehäuse 2 in das Gehäuseteil 18 eingepresst werden, wobei beim Einpressen der Schaltungsträger 5 gleichzeitig gegen die Wärmesenke 17 gepresst wird, sodass über das Wärmeleitmittel 9 eine wärmeleitfähige Verbindung zwischen dem Schaltungsträger 5 und der Wärmesenke 17 erzeugt wird.

Der Deckel 3 weist in diesem Ausführungsbeispiel einen Rand 16 auf, welcher zum Verkleben oder Laserverschweißen mit dem Gehäuse 2, insbesondere einem Rand einer Gehäusewand des Gehäuses 2 ausgebildet ist. Der Gehäusedeckel 3 weist in diesem Ausführungsbeispiel im Bereich des Durchbruchs 7 einen Verstärkungsbereich, insbesondere einen Wulst 21 auf, sodass der Gehäusedeckel 3 im Bereich des Durchbruchs 7 eine größere Dickenerstreckung aufweist als außerhalb des Wulstes 21. Mittels des Wulstes 21 ist für den Andruckbolzen 14 ein Gleitlager gebildet. Der Gehäusedeckel 3 weist im Bereich des Durchbruchs 8 einen eine Dickenverstärkung bildenden Wulst 22 auf, welcher den Durchbruch 8 umgibt, sodass durch den Wulst 22 ein insbesondere hohlzylindrisch geformtes Gleitlager für den Andruckbolzen 15 gebildet ist.

Der Andruckbolzen 14 weist in diesem Ausführungsbeispiel einen Vorsprung 23 auf, welcher quer von einer Längserstreckung des Andruckbolzens 14 abweist. Der Vorsprung 23 ist in diesem Ausführungsbeispiel durch einen umlaufend gebildeten Kragen gebildet. Der Andruckbolzen 14 ist in diesem Ausführungsbeispiel zylinderförmig ausgebildet. Mittels des Vorsprungs 23 kann verhindert werden, dass der Andruckbolzen 14 nach einer Montage des Gehäuses 2 aus dem Gehäuse 2 herausfallen kann. Der Andruckbolzen 15 weist in diesem Ausführungsbeispiel einen kragenförmigen Vorsprung 24 auf, welcher von einer Längserstreckung des Andruckbolzens 15 radial abweisend an den Andruckbolzen 15 angeformt ist. Der Andruckbolzen 15 kann so aus dem Gehäuse 2 nicht herausfallen.
Die Vorrichtung 1 umfasst in diesem Ausführungsbeispiel auch drei elektrische Verbindungsleitungen 26, 27 und 28, welche den Schaltungsträger 5 mit dem Elektromotor 25 verbinden. Die Verbindungsleitungen 26, 27 und 28 sind jeweils mit dem Schaltungsträger 5 elektrisch verbunden und erstrecken sich durch das Wärmeleitmittel 9 und durch einen jeweils für die Verbindungsleitungen gebildeten Durchbruch in der Wärmesenke 17 hindurch in den Hohlraum des Gehäuseteils 18, in dem der Elektromotor 25 aufgenommen ist. Der Elektromotor 25 kann so über die Verbindungsleitungen von der Leistungsendstufe, insbesondere dem Schaltungsträger 5, bestromt werden. Der Elektromotor 25 weist in diesem Ausführungsbeispiel einen Schneid-Klemm-Kontakt 29 für die Verbindungsleitung 26, einen Schneid-Klemm-Kontakt 30 für die Verbindungsleitung 27 und einen Schneid-Klemm-Kontakt 31 für die Verbindungsleitung 28 auf. Die Verbindungsleitungen 26, 27 und 28 können beim Einpressen des Gehäuses 2 in das Gehäuseteil 18 den Elektromotor 25 über die Schneid-Klemm-Kontakte 29, 30 beziehungsweise 31 kontaktieren.

Der Elektromotor 25 ist in diesem Ausführungsbeispiel ein dreiphasig ausgebildeter Elektromotor. In einer anderen Ausführungsform weist der Elektromotor 25 mehr als drei Phasen, beispielsweise fünf, sechs, zwölf oder achtzehn Phasen auf.

Die Halbleiterbausteine 12 und 13 bilden beispielsweise jeweils eine Leistungsendstufe zum Ansteuern des Elektromotors 25.

Dargestellt ist auch eine Pressvorrichtung 46, welche zwei Pressdome 47 und 48 aufweist, und welche ausgebildet ist, mittels des Pressdoms 47 die Kraft 19 auf ein aus dem Gehäusedeckel 3 herausragendes Ende des Andruckbolzens 14 aufzubringen und mittels des Pressdomes 48 die Kraft 20 auf ein aus dem Gehäusedeckel 3 herausragendes Ende des Andruckbolzens 15 aufzubringen. Vor oder nach dem Einpressen des Gehäuses 2 in das Gehäuseteil 18 mittels der Pressvorrichtung 46, kann der Gehäusedeckel 3, insbesondere der Rand 16, mittels von einem Laser 49 erzeugter Laserstrahlen 50 mit dem Gehäuse 2, insbesondere einem Öffnungsrand des Gehäuses 2, verschweißt werden.

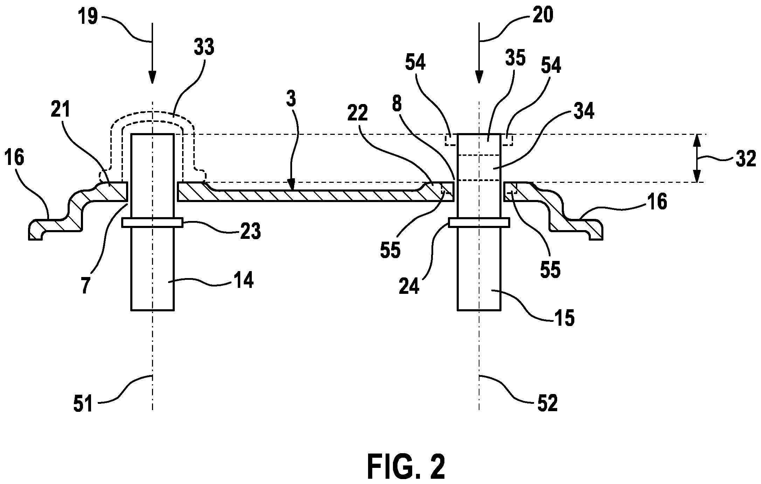

Figur 2 zeigt - schematisch - den in Figur 1 bereits auf das Gehäuse 2 aufgesetzt dargestellten Gehäusedeckel 3 in einer Schnittdarstellung. Die Andruckbolzen 14 und 15 ragen in der in Figur 2 gezeigten Darstellung aus dem Gehäusedeckel 3 heraus. Die Andruckbolzen 14 und 15 können jeweils mittels der Kraft 19 beziehungsweise 20 beaufschlagt werden, wobei die Andruckbolzen 14 und 15 in dem Durchbruch 7 beziehungsweise 8 entlang ihrer Längserstreckung 51 beziehungsweise 52 verschoben werden können. Der Andruckbolzen 15 ragt vor einem Beaufschlagen mit der Kraft 20 auf ein aus dem Gehäusedeckel 3 herausragendes Ende mit einem Endabschnitt 32 aus dem Gehäusedeckel 3 und dem den Durchbruch 8 umgebenden Wulst 22 heraus. Der Endabschnitt 32 des Andruckbolzens 15 kann so auch von Weitem gut gesehen werden, sodass leicht erkannt werden kann, dass nach einem Aufsetzen des in Figur 1 dargestellten Gehäuses 2 auf den Gehäuseteil 18 der Vorrichtung 1 die Kraft 20 auf das zuvor genannte Ende des Endabschnitts 32 noch nicht beaufschlagt worden ist.

Ein Längsabschnitt 34 des Andruckbolzens 15, welcher einen Teil des Endabschnitts 32 bildet, weist in diesem Ausführungsbeispiel eine Signalfarbe auf. Die Signalfarbe ist beispielsweise Rot, Gelb oder Orange. Dadurch kann der Andruckbolzen von außen gut von einem menschlichen Auge erfasst werden. Nach einem Einschieben des Endabschnitts 32 ist der Längsabschnitt 34 in dem Hohlraum 4 aufgenommen, sodass durch die Unsichtbarkeit der Signalfarbe des Längsabschnitts 34 in einer Aufsicht von außen auf den Gehäusedeckel 3 eine korrekte Montage des Gehäusedeckels 3 gemeinsam mit dem Gehäuse 2 leicht - beispielsweise mittels eines menschlichen Auges oder mittels einer elektronischen Erfassungsvorrichtung - erfasst werden kann.

Zusätzlich oder unabhängig zu dem Vorsprung 24 kann an dem Bolzen 15 - gestrichelt angedeutet - ein weiterer kragenförmiger Vorsprung 54 ausgebildet sein, so dass der Bolzen in dem Gehäusedeckel 3 vor einem Herausfallen gesichert ist. In dem Wulst kann eine zu dem Vorsprung 54 entsprechende Aussparung 55 ausgebildet sein, so dass der Bolzen 15 nach einem Einfahren in den Hohlraum 4 mit dem Gehäusedeckel 3 bündig abschließen kann. Die Bolzen 14 und 15 können jeweils wenigstens auf einem Längsabschnitt hohlzylindrisch ausgebildet sein. Dadurch kann vorteilhaft Material eingespart werden. Weiter vorteilhaft kann der Andruckbolzen auch mit dem durch den Vorsprung 24 oder 54 gebildeten Kragen nach einem Spritzgießen zwangsentformt werden, wobei eine Wand, insbesondere Zylinderwand des Andruckbolzens im Bereich des Vorsprungs 24 oder 54 in den Hohlraum des Hohlzylinders einfedern kann.

Die Andruckbolzen 14 und 15 können jeweils mit oder ohne dem farbig ausgebildeten Längsabschnitt 34 ausgebildet sein.

Die Andruckbolzen können jeweils zwei entlang der Längserstreckung des Andruckbolzens voneinander beabstandete insbesondere kragenförmig ausgebildete Vorsprünge aufweisen, welche den Durchbruch zwischeneinander einschließen und ausgebildet sind, den Andruckbolzen gegen ein Herausfallen aus dem Gehäusedeckel formschlüssig zu sichern.

Figur 2 zeigt auch eine gestrichelt dargestellte Variante zu dem Gehäusedeckel 3. Gestrichelt dargestellt ist eine elastisch ausgebildete Verschlusshaube 33, welche den Endabschnitt 32 des Andruckbolzens 14 umschließt. Die elastisch ausgebildete Verschlusshaube 33 kann beispielsweise mit dem Gehäusedeckel 3, insbesondere dem Wulst 21 mittels eines Klebstoffs verklebt oder mit dem Wulst 21 steckverbunden sein. Die Verschlusshaube 33 ist ausgebildet, ein Eindringen von Medien, insbesondere Öl oder Wasser, in den Hohlraum 4 zu verhindern.

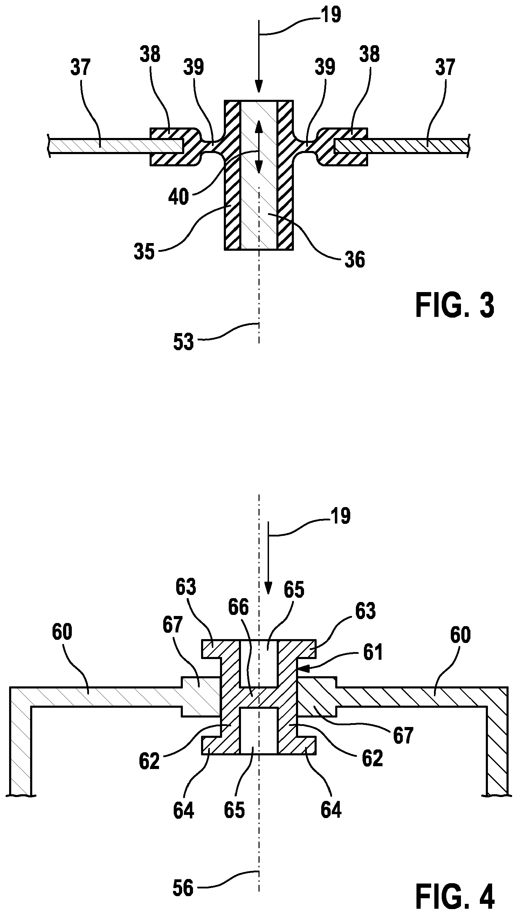

Figur 3 zeigt - schematisch - eine Ausführungsform für einen teilweise in einer Schnittdarstellung dargestellten Gehäusedeckel 37, der einen Andruckbolzen 35 aufweist, welcher in dem Gehäusedeckel 37 entlang einer Längserstreckung 53 des Andruckbolzens 35 verschiebbar gelagert ist. Die Lagerung des Andruckbolzens 35 stellt eine Variante zu der in den Figuren 1 und 2 dargestellten Gleitlagerung der Andruckbolzen 14 und 15 dar. Der Andruckbolzen 35, welcher in diesem Ausführungsbeispiel zylindrisch ausgebildet ist, ist über eine elastisch ausgebildete Federlippe 39 mit dem Deckel 37 verbunden. Die Federlippe 39 mündet radial von der Längserstreckung 53 abweisend in einen umlaufend ausgebildeten Kragen 38, in welchem eine Nut zur Aufnahme eines Durchbruchrandes des Deckels 37 ausgebildet ist. Der Andruckbolzen 35 ist somit entlang der Längserstreckung 53 längsaxial gelagert und kann so entlang der Längserstreckung 53 eine Hin- und Herbewegung 40 ausführen.

Der Andruckbolzen 35 kann beispielsweise anstelle des Andruckbolzens 14 in Figur 1 Bestandteil der Vorrichtung 1 sein. Zum Andrücken des Schaltungsträgers 5 kann die Kraft 19 - beispielsweise mittels der Pressvorrichtung 46 - auf ein aus dem Gehäusedeckel 37 herausragendes Ende des Andruckbolzens 35 aufgebracht werden. Der Andruckbolzen 35 kann so - gehalten durch die Lippe 39 - entlang der Längserstreckung 53 in den Hohlraum 4 hineinfedern und dort die Kraft 19 auf den Schaltungsträger 5 übertragen.

Der Andruckbolzen 35 kann beispielsweise mittels eines Mehrkomponenten-Spritzguss-Verfahrens gemeinsam mit dem Deckel 37 erzeugt werden. Der Deckel 37 kann beispielsweise durch einen Thermoplast gebildet sein. Der Andruckbolzen 35 kann beispielsweise gemeinsam mit der Dichtlippe 39 und dem Kragen 38 durch ein Elastomer gebildet sein. Der Andruckbolzen 35 kann beispielsweise einen Kern 36 aufweisen, welcher entlang der Längserstreckung 53 in dem Andruckbolzen 35 ausgebildet ist. Der Kern 36 ist in diesem Ausführungsbeispiel in das Elastomer-Material des Andruckbolzens 35 eingebettet. Die Kraft 19 kann so auf den Kern 36 wirken, welcher eine größere Steifigkeit aufweist als das Elastomer-Material des Andruckbolzens 35. Der Kern 36 ist beispielsweise durch einen Kunststoff mit einer größeren Steifigkeit gebildet als der Andruckbolzen 35, beispielsweise durch einen Duroplast oder durch ein Metall oder ein Keramikmaterial.

Figur 4 zeigt - schematisch - ein Ausführungsbeispiel für einen Gehäusedeckel 60 in einer Schnittdarstellung. Der Gehäusedeckel 60 weist einen in einem Durchbruch des Gehäusedeckels 60 entlang einer Längsachse 56 verschiebbar gelagerten Andruckbolzen 61 auf. Der Andruckbolzen 61 weist eine insbesondere hohlzylindrisch ausgebildete Hülse 62 auf, welche einen Hohlraum 65 umschließt. An zwei zueinander gegenüberliegenden Enden des Andruckbolzens 61 sind zwei sich jeweils quer zur Längsachse 56 erstreckende Kragen 63 und 64 angeformt, so das der Andruckbolzen 61 in dem Gehäusedeckel 60 entlang der Längsachse 56 formschlüssig gesichert ist und nicht herausfallen kann.

Der Gehäusedeckel weist im Bereich des Durchbruchs einen den Gehäusedeckel verstärkenden Wulst 67 auf, welcher den Andruckbolzen umschließt. Durch den Wulst 67 ist ein Gleitlager für den Andruckbolzen 61 gebildet.

Im Inneren der Hülse erstreckt sich ein Steg 66, welcher die Hülsenwand im Bereich einer Mitte der Hülse 62 stützt. Die Hülse 62 kann so an dem Kragen 63 und/oder dem Kragen 64 zusammengepresst werden und in den Hohlraum 65 einfedern. Dadurch kann ein den Andruckbolzen 61 erzeugendes Spritzgusswerkzeug entlang der Längsachse 56 entgegen dem durch den Kragen 63 oder 64 gebildeten Hinterschnitt abgezogen werden und der Andruckbolzen so zwangsentformt werden. Der Gehäusedeckel 60 kann beispielsweise mittels Montagespritzguss erzeugt werden, wobei der Gehäusedeckel 60 in einem ersten Schritt erzeugt wird und in einem darauf folgenden zweiten Schritt der Andruckbolzen 61 in dem Durchbruch erzeugt wird.

Der Andruckbolzen ist beispielsweise aus POM gebildet und der Gehäusedeckel aus faserverstärktem PBT. Der Andruckbolzen 61 kann anstelle des Andruckbolzens 13 und/oder 14 als Bestandteil des Gehäusedeckels 3 in Figur 1 verwirklicht sein.
Der Andruckbolzen 60 kann mittels einer Kraft 19 beaufschlagt werden und in dem Durchbruch entlang der Längsachse 56 verschoben werden.

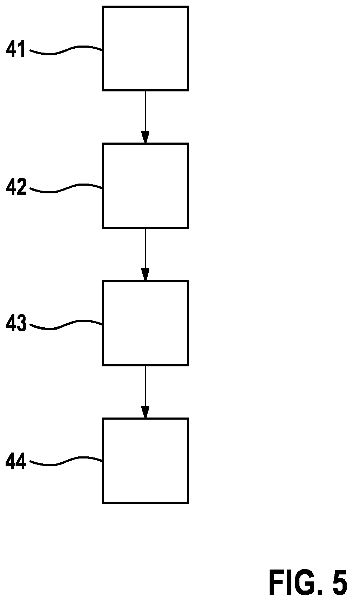

Figur 5 zeigt ein Schema für ein Verfahren zum Erzeugen einer elektrischen Vorrichtung wie der elektrischen Vorrichtung 1 in Figur 1, beispielsweise dem in Figur 1 dargestellten Elektromotor.

In einem Verfahrensschritt 41 wird ein Gehäuse 2, in dem ein Schaltungsträger 5 aufgenommen ist, auf einem weiteren Gehäuseteil 18 aufgesetzt. In einem weiteren Schritt 42 wird ein Gehäusedeckel, in dem wenigstens ein Andruckbolzen, beispielsweise die Andruckbolzen 14 und 15, längsaxial verschiebbar gelagert sind, auf das Gehäuse 2 aufgesetzt, sodass eine Gehäuseöffnung des Gehäuses 2 verschlossen wird. Der Andruckbolzen wie der Andruckbolzen 14 oder der Andruckbolzen 15 ragen dabei mit einem Endabschnitt, beispielsweise dem in Figur 2 dargestellten Endabschnitt 32, aus dem Gehäusedeckel 3 heraus. In einem weiteren Schritt 43 wird der Gehäusedeckel 3 mittels Laserstrahlen, beispielsweise den in Figur 1 dargestellten Laserstrahlen 50, mit dem Gehäuse 2 laserverschweißt. In einem weiteren Schritt 44 wird mittels einer Pressvorrichtung 46 eine Kraft, insbesondere die Kraft 19 und/oder die Kraft 20, auf den wenigstens einen Andruckbolzen wie die Andruckbolzen 14 und 15 in Figur 1 aufgebracht, sodass die Andruckbolzen in den Hohlraum 4 eingefahren werden und mit einem in den Hohlraum 4 weisenden Ende, das dem aus dem Gehäusedeckel 3 herausragenden Ende gegenüberliegt, auf den Schaltungsträger 5 gepresst. Der Schaltungsträger 5 wird so gegen eine Wärmesenke, insbesondere die in Figur 1 dargestellte Wärmesenke 17, gepresst, sodass ein Wärmeleitmittel, insbesondere ein Wärmeleitklebstoff, oder eine Wärmeleitpaste einen Zwischenraum zwischen dem Schaltungsträger 5 und der Wärmesenke 17 fast vollständig oder vollständig ausfüllen kann. Mit der Kraft 19 und/oder der Kraft 20 kann auch das Gehäuse 2, insbesondere die Wärmesenke, beispielsweise die in Figur 1 dargestellte Wärmesenke 17, mit dem weiteren Gehäuseteil 18, insbesondere der in Figur 1 dargestellten Motorhülse, verpresst werden. Vorteilhaft werden beim Beaufschlagen der Kraft auf den wenigstens einen Andruckbolzen elektrische Kontakte, welche mit dem Schaltungsträger, insbesondere dem Schaltungsträger 5 in Figur 1, verbunden sind, mit einer elektrischen Maschine, insbesondere Elektromotor und/oder Generator, elektrisch verbunden. Die elektrische Verbindung ist beispielsweise eine Schneid-Klemm-Verbindung oder eine Steckverbindung.

## Patentansprüche

1. Elektrische Vorrichtung (1) mit einem Gehäuse (2) und wenigstens einer Leiterplatte (5, 6) und einer Wärmesenke (17), wobei das Gehäuse (2) einen Hohlraum (4) umschließt und die Leiterplatte (5, 6) in dem Hohlraum (4) aufgenommen ist, und die Leiterplatte (5) mit der Wärmesenke (17) wärmeleitfähig verbunden ist,
**dadurch gekennzeichnet, dass**
das Gehäuse (2) einen Gehäusedeckel (3) aufweist, wobei der Gehäusedeckel (3) wenigstens einen, zwei oder drei quer zu einer flachen Erstreckung des Gehäusedeckels (3) entlang einer Längsachse (51, 52, 53, 56) verschiebbar gelagerten Andruckbolzen (14, 15, 35) oder Andruckstift aufweist, welcher ausgebildet ist, in den Hohlraum (4) eingeschoben zu werden und mindestens mittelbar oder unmittelbar gegen die Leiterplatte (5) anzudrücken und die Leiterplatte (5) so gegen die Wärmesenke (17) zu pressen.

2. Vorrichtung (1) nach Anspruch 1,
**dadurch gekennzeichnet, dass**
in dem Gehäusedeckel (3) ein Gleitlager (21, 22) für den Andruckbolzen (14, 15) ausgebildet ist.

3. Vorrichtung (1) nach einem der Ansprüche 1 oder 2,
**dadurch gekennzeichnet, dass**
der Andruckbolzen (14, 15) und der Gehäusedeckel (3) jeweils aus zueinander verschiedenen Kunststoffen gebildet sind.

4. Vorrichtung (1) nach Anspruch 1,
**dadurch gekennzeichnet, dass**
der Gehäusedeckel (3) eine im Bereich des Andruckbolzens (13) ausgebildete, elastisch ausgebildete Lippe (39) oder Membran aufweist, welche den Andruckbolzen (35) umgibt und mit dem Gehäusedeckel (37) verbindet, so dass der Andruckbolzen (35) in dem Gehäusedeckel (37) federnd axial verschiebbar gelagert ist.

5. Vorrichtung (1) nach Anspruch 4,
**dadurch gekennzeichnet, dass**
die Lippe (39) mit dem Andruckbolzen (35) und dem Gehäusedeckel (37) stoffschlüssig verbunden ist.

6. Vorrichtung (1) nach einem der vorhergehenden Ansprüche,
**dadurch gekennzeichnet, dass**
die Leiterplatte (5) mit der Wärmesenke mittels eines Wärmeleitmittels (9), insbesondere eines wärmeleitfähigen Klebstoffs verbunden ist.

7. Verfahren zum Andrücken einer Leiterplatte (5) an eine Wärmesenke (17),
- bei dem die Leiterplatte (5) in einem Hohlraum (4) eines Gehäuses (2) eingebracht wird;
- und dort mit ihrer flachen Erstreckung einer Wärmesenke (17) gegenüberliegt, die wenigstens einen Teil eines Gehäusebodens des Gehäuses (2) bildet;
- und das Gehäuse (2) mit einem Gehäusedeckel (3) verschlossen wird,
- wobei wenigstens ein oder mehrere in dem Gehäusedeckel (3) axial verschiebbar gelagerte Andruckbolzen (14, 15, 35) von Außen auf ein nach Außen ragendes Ende mit einer Andruckkraft (19, 20) beaufschlagt werden, und so in den Hohlraum (4) hineingedrückt werden und dort die Leiterplatte (5) gegen die Wärmesenke (17) anpressen.

8. Verfahren nach Anspruch 7,
**dadurch gekennzeichnet, dass**
die Leiterplatte (5) beim Angedrücktwerden mit der Wärmesenke (17) wärmeleitfähig verbunden wird.

9. Verfahren nach Anspruch 7 oder 8,
**dadurch gekennzeichnet, dass**
der Andruckbolzen (14, 15) nach dem Eingedrücktwerden in den Gehäusedeckel mit dem Gehäusedeckel bündig abschließt.

10. Verfahren nach einem der Ansprüche 7 bis 9,
bei dem der Andruckbolzen (14, 15) beim Eingedrücktwerden in den Hohlraum in einem Durchbruch des Gehäusedeckels gleitet.

11. Verfahren nach einem der vorhergehenden Ansprüche 7 bis 10,
bei dem beim Einpressen der Andruckbolzen (14, 15) das Gehäuse (2) zusammen mit der Wärmesenke (17) in eine ein Gehäuseteil (18) bildende Hülse, insbesondere Motorhülse eingepresst wird.

## Claims

1. Electric device (1), comprising a housing (2) and at least one printed circuit board (5, 6) and one heat sink (17), the housing (2) enclosing a cavity (4), and the printed circuit board (5, 6) being received in the cavity (4), and the printed circuit board (5) being connected to the heat sink (17) so as to conduct heat, **characterized in that** the housing (2) has a housing cover (3), the housing cover (3) having at least one, two or three pressing bolts (14, 15, 35) or pressing pins which are mounted so as to be slidable transversely to a planar extent of the housing cover (3) along a longitudinal axis (51, 52, 53, 56), which bolts or pins are designed to be inserted into the cavity (4) and to be pressed against the printed circuit board (5) at least directly or indirectly and thus press the printed circuit board (5) against the heat sink (17).

2. Device (1) according to Claim 1, **characterized in that** a sliding bearing (21, 22) for the pressing bolt (14, 15) is formed in the housing cover (3).

3. Device (1) according to either Claim 1 or Claim 2, **characterized in that** the pressing bolt (14, 15) and the housing cover (3) are each formed from plastics materials which are different from one another.

4. Device (1) according to Claim 1, **characterized in that** the housing cover (3) comprises a resiliently formed lip (39) or membrane which is formed in the region of the pressing bolt (13) and encloses the pressing bolt (35) and connects said bolt to the housing cover (37) so that the pressing bolt (35) is mounted in the housing cover (37) so as to be able to slide in a resilient, axial manner.

5. Device (1) according to Claim 4, **characterized in that** the lip (39) is integrally bonded to the pressing bolt (35) and the housing cover (37).

6. Device (1) according to any of the preceding claims, **characterized in that** the printed circuit board (5) is connected to the heat sink by a heat-conducting means (9), in particular a heat-conductive adhesive.

7. Method for pressing a printed circuit board (5) onto a heat sink (17),
- in which the printed circuit board (5) is introduced into a cavity (4) in a housing (2);
- and in said cavity, the planar extent of said printed circuit board is opposite a heat sink (17) which forms at least part of a housing base of the housing (2);
- and the housing (2) is closed by a housing cover (3),
- wherein at least one or more pressing bolts (14, 15, 35) which are mounted in ,an axially slidable manner in the housing cover (3) have a pressing force (19, 20) applied to the outwardly protruding end thereof from outside and are thus pressed into the cavity (4) and, in said cavity, press the printed circuit board (5) against the heat sink (17).

8. Method according to Claim 7, **characterized in that** the printed circuit board (5) is connected to the heat. sink (17) so as to conduct heat while being pressed onto said heat sink.

9. Method according to either Claim 7 or Claim 8, **characterized in that** the pressing bolt (14, 15) finishes flush with the housing cover after being pressed into the housing cover.

10. Method according to any of Claims 7 to 9, wherein the pressing bolt (14, 15) slides into an aperture in the housing cover while being pressed into the cavity.

11. Method according to any of the preceding Claims 7 to 10, wherein, while pressing in the pressing bolt (14, 15), the housing (2) is pressed, together with the heat sink (17), into a sleeve forming a housing part (18), in particular a motor sleeve.

## Revendications

1. Dispositif électrique (1) comprenant un boîtier (2) et au moins une carte de circuit imprimé (5, 6) et un dissipateur de chaleur (17), dans lequel le boîtier (2) renferme une cavité (4) et la carte de circuit imprimé (5, 6) est logée dans la cavité (4), et la carte de circuit imprimé (5) est reliée de manière thermiquement conductrice au dissipateur de chaleur (17),
**caractérisé en ce que**
le boîtier (2) comporte un couvercle de boîtier (3), dans lequel le couvercle de boîtier (3) présente au moins un, deux ou trois boulons presseurs (14, 15, 35) ou tiges presseuses montés de manière à pouvoir coulisser le long d'un axe longitudinal (51, 52, 53, 56) transversalement à une extension plane du couvercle de boîtier (3), lequel boulon presseur ou laquelle tige presseuse est conçu pour être inséré dans la cavité (4) et presser au moins indirectement ou directement la carte de circuit imprimé (5) et presser ainsi la carte de circuit imprimé (5) contre le dissipateur de chaleur (17).

2. Dispositif (1) selon la revendication 1,
**caractérisé en ce qu'**un palier lisse (21, 22) destiné au boulon presseur (14, 15) est réalisé dans le couvercle de boîtier (3).

3. Dispositif (1) selon l'une des revendications 1 ou 2,
**caractérisé en ce que** le boulon presseur (14, 15) et le couvercle de boîtier (3) sont respectivement formés de deux matières plastiques différentes.

4. Dispositif (1) selon la revendication 1,
**caractérisé en ce que** le couvercle de boîtier (3) présente une lèvre (39) ou une membrane réalisée de manière élastique, formée dans la zone du boulon presseur (13), qui entoure le boulon presseur (35) et le relie au couvercle de boîtier (37), de manière à ce que le boulon presseur (35) soit monté dans le couvercle de boîtier (37) afin de pouvoir coulisser axialement de façon élastique.

5. Dispositif (1) selon la revendication 4,
**caractérisé en ce que** la lèvre (39) est reliée au boulon presseur (35) et au couvercle de boîtier (37) par complémentarité de matière.

6. Dispositif (1) selon l'une des revendications précédentes,
**caractérisé en ce que** la carte de circuit imprimé (5) est reliée au dissipateur de chaleur au moyen d'un agent thermiquement conducteur (9), en particulier d'un adhésif thermiquement conducteur.

7. Procédé pour presser une carte de circuit imprimé (5) contre un dissipateur de chaleur (17),
- dans lequel la carte de circuit imprimé (5) est placée dans une cavité (4) d'un boîtier (2) ;
- et dans celle-ci, se trouve avec son extension plane en face d'un dissipateur de chaleur (17) qui forme au moins une partie de fond de boîtier du boîtier (2) ;
- et le boîtier (2) est refermé par un couvercle de boîtier (3),
- dans lequel au moins un ou plusieurs boulons presseurs (14, 15, 35) montés de manière à pouvoir coulisser axialement dans le couvercle de boîtier (3) sont soumis de l'extérieur à une force de pression (19, 20) sur une extrémité faisant saillie vers l'extérieur, et sont ainsi enfoncés dans la cavité (4) et pressent dans celle-ci la carte de circuit imprimé (5) contre le dissipateur de chaleur (17).

8. Procédé selon la revendication 7,
**caractérisé en ce que** la carte de circuit imprimé (5) est reliée de manière thermiquement conductrice au dissipateur de chaleur (17) lorsqu'elle est pressée.

9. Procédé selon la revendication 7 ou 8,
**caractérisé en ce que** le boulon presseur (14, 15), après avoir été enfoncé dans le couvercle de boîtier, est affleurant avec le couvercle de boîtier.

10. Procédé selon l'une des revendications 7 à 9,
dans lequel le boulon presseur (14, 15), après avoir été enfoncé dans la cavité, coulisse dans une ouverture du couvercle de boîtier.

11. Procédé selon l'une des revendications 7 à 10 précédentes,
dans lequel, lors de l'enfoncement des boulons presseurs (14, 15), le boîtier (2) est pressé avec le dissipateur de chaleur (17) dans une douille, en particulier une douille de moteur, formant une partie de boîtier (18).
